Europäisches Patentamt

European Patent Office

Office européen des brevets

(19)

(11) Publication number: 0 042 943

A1

(12) **EUROPEAN PATENT APPLICATION**

(21) Application number: 81103611.0

(22) Date of filing: 12.05.81

(51) Int. Cl.³: **H 01 L 21/88**
H 01 L 23/52, H 05 K 3/46

(30) Priority: 02.07.80 US 165319

(43) Date of publication of application:
06.01.82 Bulletin 82/1

(84) Designated Contracting States:
DE FR GB IT

(71) Applicant: International Business Machines
Corporation

Armonk, N.Y. 10504(US)

(72) Inventor: Franchak, Nelson Peter
Smith Road
Binghamton, N.Y. 13905(US)

(72) Inventor: Funari, Joseph
149 Meeker Road
Vestal, N.Y. 13850(US)

(72) Inventor: Hoffman, Herman Sol
Route 7 R.D. 3
Milton Vermont 05468(US)

(72) Inventor: Rivenburgh, Dennis Louis
804 Buffalo Road
Endicott New York 13760(US)

(74) Representative: Barth, Carl O., Dipl.-Ing.
IBM Europäische Patentdienste Rablstrasse 24
D-8000 München 80(DE)

(54) Multilayer integrated circuit substrate structure and process for making such structures.

(57) Provided are a process for making and a structure of a multilayer integrated circuit substrate having improved via connection. A first layer M1 (20-22) of chrome-copper-chrome is applied to a ceramic substrate (19) and the circuits etched. A polyimide layer (23) is then applied, cured, and developed and etched to provide via holes in the polyimide layer down to the M1 circuitry. The top chrome (22) is now etched to expose the M1 copper (21) in the via holes. Next, a coating of tin (27) is applied to all exposed copper surfaces. This is followed by evaporation of a second layer M2 (24-26) of chrome-copper-chrome and during the evaporation cycle, the tin is in a molten state which causes the chrome to break up as it is deposited and migrates some of the chrome to the periphery of the vias. As a result, a tin interface is formed which provides a metallurgical bond between the M1 copper (21) and the M2 copper (25).

FIG. 2

# MULTILAYER INTEGRATED CIRCUIT SUBSTRATE STRUCTURE AND PROCESS FOR MAKING SUCH STRUCTURES

MCP or metallized ceramic polyimide integrated circuit substrate structures comprise a ceramic substrate on which is evaporated a first layer M1 of chrome-copper-chrome, on which printed circuitry is formed on the copper, a layer of polyimide, and a second evaporated layer M2 of chrome-copper-chrome, on which printed circuitry is formed on the copper. Via holes are formed in the polyimide, prior to the deposition of the M2 layer, which extend down to the copper circuitry of the M1 layer and which conductively connect the circuitry on the M1 and M2 layers.

The above basic structure has presented problems in that there is no solubility of copper in chrome and, as a result, in the vias the bond between the copper of the M1 layer and the chrome of the M2 layer is a mechanical bond or coupling. Also, the top chrome of layer M1 is removed chemically at the bottom of the vias leaving copper which is exposed to air prior to the deposition of the M2 layer which results in oxidation. As such, this bonding system which depends entirely on a mechanical coupling and is extremely sensitive to film oxidation and/or contaminants at the metal to metal interface did not provide the desired adhesion and also created undue electrical resistance in the vias.

Subsequently, it was proposed to modify the above process to improve the inter-connection between the M1 and M2 layers by employing an immersion gold solution. This modification is described in the IBM Technical Disclosure Bulletin, Vol. 22, No. 4, September 1979, pages 1420-1421. The gold solution is applied immediately prior to evaporation of the M2 layer. During evaporation of the M2 layer of chrome-copper-chrome, the gold forms a metal-to-metal bond with the M1 copper layer and it also penetrates through the M2 bottom porous chrome layer to make contact with the M2 copper layer. This process provides good adhesion between the M1 and M2 layers and also provides a desirable via resistance, however, it proved to be expensive and time consuming. The process requires that each substrate be immersed in the gold solution bath for approximately 45 minutes and the cost of processing is quite high. In the processing of large quantities of substrates, it became evident that there was need for a process which was less time consuming and less costly and which would still provide the desired adhesion and via resistance.

The present invention solves this problem. It greatly reduces the processing time and cost of the aforementioned prior art by providing the desired adhesion between the M1 and M2 layers and the desired via resistance. This is accomplished by using an immersion tin solution in the above-described process instead of gold to make the interconnection between the M1 and M2 layers. The top chrome of layer M1 is removed chemically at the bottom of the vias in the substrates to expose the copper. A hot de-ionized bath is used to wet all the exposed copper surfaces and then an immersion tin bath is used to apply tin to all of the exposed copper surfaces. The thickness of the tin is controlled by the length of time the substrates are in the bath. The substrates are then rinsed in hot de-ionized water to remove any residue and air dried to remove the moisture.

The M2 layer of chrome-copper-chrome is now evaporated on the tin at $300^{\circ}C$ in a vacuum. During the evaporation cycle, the tin, which melts at around $232^{\circ}C$, goes into a molten state which causes the chrome to break up as it is de-

EN 980 003

posited. When the bottom chrome of the M2 layer is evaporated, it actually condenses on the liquid tin. This has the effect of interrupting the continuity of the chrome film at this interface because movement of the molten tin disrupts the chrome film nucleation and surface cohesive effects cause some of the depositing chrome to migrate to the periphery of the vias. Voids are created in the chrome which results in very good diffusion and bond between the tin and the M1 and M2 copper layers.

An advantage in using tin as an interface is that it is more feasible than gold, for example, to apply and it can be applied with a thickness substantial enough to leave a rough surface which breaks up the M2 bottom chrome layer when it is evaporated thereon. Another significant advantage in the use of tin is that it greatly reduces process time and cost. Tin immersion can be done in larger batches and only requires from 3 to 5 minutes immersion time per substrate. Also, the tin process substantially reduces the cost per substrate down to approximately one tenth of the cost using the prior art process.

Thus, the present invention provides a more feasible and economical process for making via connections in multilayer integrated circuit substrates.

Also, the present invention provides a multilayer integrated circuit substrate having a first layer of chrome-copper-chrome, a layer of polyimide, a second layer of chrome-copper-chrome, and via connections having a tin interface bonded between the copper of said first and second layers.

Details of the invention will be apparent from the following more particular description of an embodiment of the invention, as illustrated in the accompanying drawings, in which:

Fig. 1        illustrates in cross section a prior art conductive via connection in a multilayer integrated circuit substrate; and-

Fig. 2        illustrates in cross section a conductive via connection in a multilayer integrated circuit substrate, prepared by the method of the present invention.

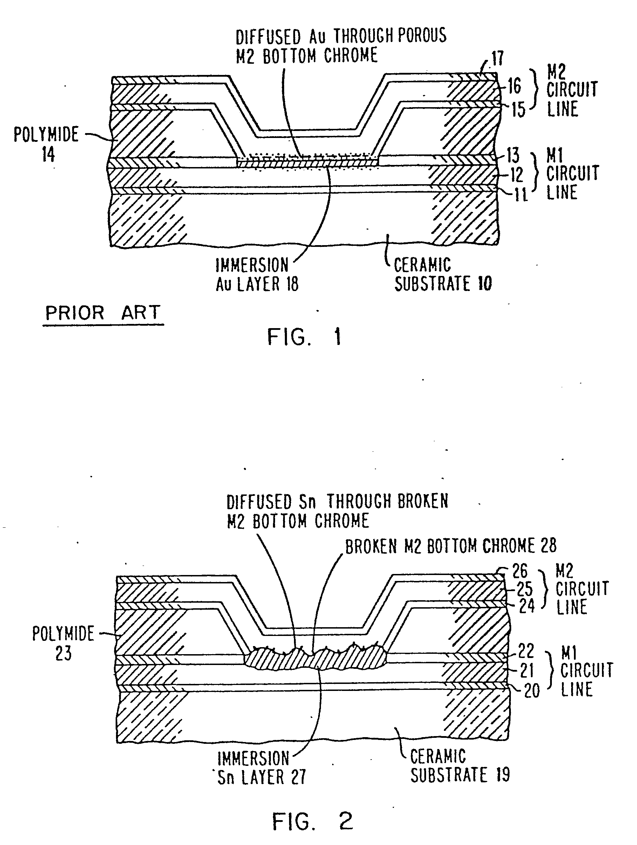

Referring to Fig. 1, there is illustrated the previously mentioned prior art multilayer integrated circuit substrate having a gold inter-connection between the M1 and M2 circuit line layers of chrome 11, copper 12, and chrome 13. Over the M1 layer of chrome 13 is a layer of polyimide 14 and on the polyimide is an M2 circuit line layer of chrome 15, copper 16, and chrome 17. Prior to the application of the M2 circuit line layer, via holes are etched in the polyimide down through the top chrome 13 of the M1 layer. Next an immersion gold solution is applied to the base of the vias to provide a layer of gold 18 on the copper 12 of the M1 layer. The M1 and M2 circuit line layers are applied by evaporation and when the M2 layer is evaporated, the gold 18 diffuses through the porous bottom chrome 15 of the M2 layer and forms a metal-to-metal bond between the copper 16 of the M2 layer and the copper 12 of the M1 layer.

The gold is put on in an electroless bath and is not in liquid form when the M2 layer is evaporated. The gold layer is very thin with a thickness in the order of 2500 Ångstroms compared to the thickness of the copper which is around 80 000 Ångstroms. The gold migrates down to form a good bond with the copper 12 of the M1 layer but a much lesser bond with the copper 16 of the M2 layer. It adheres well to the copper but will not adhere to the chrome.

Referring now to Fig. 2, there is illustrated the present improved via hole arrangement in a multilayer integrated circuit substrate. The circuit substrate is similar to the above-described prior art except that a tin interconnection is used between the copper of the M1 and M2 circuit line layers instead of gold. As will be described, the use of tin provides certain advantages.

This arrangement also comprises a ceramic substrate 19 on the surface of which is an M1 circuit line layer of chrome 20, copper 21, and chrome 22. Over the M1 layer of chrome 22 is a layer of polyimide 23 and on the polyimide is an M2 circuit line layer of chrome 24, copper 25, and chrome 26. Prior to the application of the M2 circuit line layer, via holes are etched in the polyimide down through the top chrome 22 of the M1 layer. Next, an immersion tin solution is applied to the base of the vias to provide a layer of tin 27 on the copper 21 of the M1 layer.

As was previously pointed out, the use of tin is more feasible, more economical, and requires less process time. Also, a layer of a greater thickness may be applied which is in the order of 40 000 Ångstroms or half the thickness of the copper. The tin is thick enough to have a rough surface and it will cover all of any chrome specs and oxides which may be at the bottom of the vias. The tin bath is also an acidic bath which etches chrome and helps to clean the vias when the tin is deposited.

The M1 and M2 circuit line layers are applied by evaporation and when the M2 layer is evaporated at 300$^\circ$C, the tin layer 27 goes into a molten state and has a thickness sufficient enough to cause the bottom chrome 22 of the M2 layer to break up into particles 28, some of which migrate to the periphery of the via. The chrome 22 thickness, when applied, is in the order of 800 Ångstroms. As a result of this action, there is excellent diffusion between the tin and the copper in both the M1 and M2 layers and a good metal-to-metal bond is created.

The present via hole arrangement and multilayer integrated circuit substrate, shown in Fig. 2, is process in the following manner:

(1) The M1 layer of chrome-copper-chrome is evaporated on the raw ceramic substrate by commercially available equipment wherein a pool of chrome and a pool of copper are contained and an electron beam is used to fire and melt the pools at $300^{\circ}C$ causing them to evaporate upward onto the substrate.

(2) Circuitization is now carried out through the use of conventional photolithography and circuits are etched on the M1 metallurgy.

(3) Following circuitization, the polyimide layer 23 is applied to the surface by spraying.

(4) After applying the polyimide to the substrate, the material is partially cured ("A" cure) at $110^{\circ}C$ for 15 minutes. The purpose of this operation is to remove excess solvent.

(5) The polyimide then goes through a control bake cycle ("B" cure) at $210^{\circ}C$ for 15 minutes to stabilize the material.

(6) A photoresist is applied, exposed and developed so that the via sites are exposed.

(7) The vias are selected and etched in the polyimide. A via at this point in time is a hole in the polyimide down to the M1 circuitry.

(8) The polyimide now goes through the final cure cycle ("C" cure) at 360°C for 30 minutes. At this point the polyimide can no longer be etched.

(9) The top chrome 22 of the M1 layer is etched to expose the copper 21 at the base of the via holes.

(10) During the "C" cure cycle, the exposed M1 circuitry is oxidized. To remove this oxide coating, the substrates go through a series of cleaning steps.

(11) The next cycle is the immersion tin cycle wherein:

(a) A hot de-ionized water bath is used to wet all the copper surfaces on the substrates.

(b) An immersion tin bath is used to apply tin to all exposed copper surfaces. The thickness of the tin is controlled by the length of time the substrates are in the bath and, as was mentioned, in the present embodiment the immersion time is from 3-5 minutes to deposit a layer of tin having a thickness of 40 000 Ångstroms.

(c) The substrates are then rinsed in hot de-ionized water to remove any residue.

(d) The substrates are then air dried to remove the moisture.

(12) The M2 layer of chrome-copper-chrome is now evaporated at 300°C in the same manner that the M1 layer was, with the bottom chrome of the M2 layer having a thickness in the order of 800 Ångstroms. The tin melts at approximately 232°C and goes into a molten state which breaks up the M2 chrome into the particles 28 which results in the improved interface between the tin and the M1 and M2 copper layers.

(13) The desired circuitry is now developed on the M2 metallurgy in the same manner that the M1 circuitry was fabricated.

EN 980 003

- 8 -

In multilayer integrated circuit substrates of the type shown and described, the M1 and M2 circuit lines are connected to via connections, as shown in Fig. 2, and also to circuit lands and I/O or input-output pins. The ceramic substrate contains pin holes which are not covered by the evaporated M1 and M2 circuit layers. Subsequently, the top chrome of the M2 layer is etched around selected pin hole locations to the copper to provide a copper ring or collar around the holes. Input-output pins are then secured in the holes and tin applied to provide a good electrical connection. The circuit lands are formed by etching away the top chrome of the M2 layer over the via, shown in Fig. 2, and filling the via with tin-lead to provide a land to which an integrated circuit chip may be soldered.

EN 980 003

C L A I M S

1. A process for making a multilayer integrated circuit substrate structure having via connections, comprising depositing a first layer (20-22) of chrome-copper-chrome onto a substrate (10), forming circuitry on said first layer, applying an insulating layer (23) preferably of polyimide, producing via holes in said insulating layer down to said circuitry, and etching the top chrome layer (22) in said first layer to expose copper in said via holes,

   characterized by

   applying a layer (27) of tin to all exposed copper surfaces in said via holes,

   evaporating a second layer (24-26) of chrome-copper-chrome onto said insulating layer, the evaporation putting said tin in a molten state which causes the bottom chrome (24) of said second layer to break up as it is deposited leaving a tin interface in said via holes which provides a metallurgical bond between the copper in said first and second chrome-copper-chrome layers, and

   forming circuitry on said second chrome-copper-chrome layer.

2. The process of claim 1, wherein the second layer (24-26) of chrome-copper-chrome is evaporated at $300^{\circ}C$ and the layer (27) of tin liquifies to a molten state at approximately $232^{\circ}C$.

EN 9 80 003

3. The process of claim 2,
   wherein the layer (27) of tin is applied to a thickness in the order of 40 000 Ångstroms.

4. The process of claim 2,
   wherein the bottom chrome layer (24) of the second layer is applied to a thickness in the order of 800 Ångstroms.

5. The process of claim 1,
   wherein both the via holes and the circuitry is produced by photoetching.

6. A multilayer integrated circuit structure comprising a substrate (19), a first layer (20-22) of chrome-copper-chrome circuitry on said substrate, an insulating layer on said first layer, and via holes formed in said insulating layer which extend to the copper of said first layer

   characterized by

   a layer (17) of tin on the exposed copper surface at the base of said via holes,

   a second layer (24-26) of chrome-copper-chrome circuitry on said insulating layer whereby a metallurgical bond is provided between said tin layer in the via holes and the copper of said first and second layers.

EN 980 003

7.  The structure of claim 6,
    wherein the substrate (19) is a ceramic substrate.

8.  The structure of claim 6,
    wherein the insulating layer (23) is a polyimide
    layer.

EN 980 003

1/1

DIFFUSED Au THROUGH POROUS
M2 BOTTOM CHROME

POLYMIDE 14

IMMERSION Au LAYER 18

CERAMIC SUBSTRATE 10

17
16 } M2 CIRCUIT
15 } LINE

13
12 } M1 CIRCUIT
11 } LINE

PRIOR ART

FIG. 1

DIFFUSED Sn THROUGH BROKEN
M2 BOTTOM CHROME

BROKEN M2 BOTTOM CHROME 28

POLYMIDE 23

IMMERSION Sn LAYER 27

CERAMIC SUBSTRATE 19

26
25 } M2 CIRCUIT
24 } LINE

22
21 } M1 CIRCUIT
20 } LINE

FIG. 2

# EUROPEAN SEARCH REPORT

**European Patent Office**

| Category | Citation of document with indication, where appropriate, of relevant passages | Relevant to claim |
|---|---|---|
| D | IBM TECHNICAL DISCLOSURE BULLETIN, Vol. 22, No. 4, September 1979, New York J. GOW III et al. "Process for Making Multilayer IC Substrate" pages 1420 to 1421 | 1 |
| | DD - A - 136 324 (UHLMANN et al.) * complete document * | 1 |
| | US - A - 3 461 357 (IBM) * column 3, lines 44 to 51 * | 1 |
| A | IBM TECHNICAL DISCLOSURE BULLETIN, Vol. 17, No. 4, September 1974 New York V.C. MARCOTTE et al. "Metallurgical Bonding of Semiconductor Pad Terminals" page 1040 | |

**CLASSIFICATION OF THE APPLICATION (Int. Cl 3)**

H 01 L 21/88
H 01 L 23/52
H 05 K 3/46

**TECHNICAL FIELDS SEARCHED (Int. Cl.3)**

H 01 L 21/60
H 01 L 21/88
H 01 L 23/48
H 01 L 23/52
H 05 K 3/46

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| Berlin | 02-10-1981 | GIBBS |

EPO Form 1503.1 06.78